# EUROPEAN PATENT APPLICATION

(11) **EP 2 290 005 A1**
(43) Date of publication of application: **02.03.2011**
(21) Application number: 10001113.9
(22) Date of filing: 03.02.2010
(51) Int. Cl.: C08L 77/10, G03F 7/023, G03F 7/022, C08K 5/23

(54) **Positive type photosensitive composition**

(30) Priority: 31.08.2009 KR 20090081182
(71) Applicant: Korea Kumho Petrochemical Co. Ltd., Chongno-gu Seoul 336-882 (KR)
(72) Inventor: Park, Joo Hyeon, Cheonan-si Chungcheongnam-do, 330-784 (KR); Cho, Jung Hwan, Busan-si, 611-801 (KR); Lee, Jin Han, Nam-gu Incheon-si, 402-014 (KR); Son, Kyung Chul, Gangreung-si Gangwon-do, 210-806 (KR)
(74) Representative: Pfenning, Meinig & Partner GbR

(57) **Abstract**

Disclosed is a positive type photosensitive composition including a polyamide derivative represented by the following Chemical Formula, 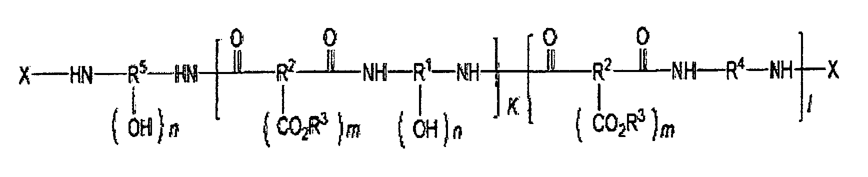 where R¹, R², R⁴, and R⁵ independently represent a bivalent to hexavalent aryl group, R³ represents either a hydrogen atom or an alkyl group with 1 to 10 carbon atoms, k represents an integer of 10 to 1,000, 1 represents an integer of 1 to 1,000, n and m independently represent an integer of 0 to 2 (n+m>0), and X represents either a hydrogen atom or an aryl group with 2 to 30 carbon atoms.

## Description

### BACKGROUND

### 1. Field of the Invention

The present invention relates to a heat-resistant positive typed photosensitive composition that may be readily crosslinked even at a relatively low temperature in a semiconductor process while having high sensitivity, thereby reducing an occurrence of defects in the semiconductor due to a relatively high temperature.

### 2. Description of the Related Art

In general, most photosensitive compositions used in a semiconductor process may exhibit a positive type, because an exposed portion is dissolved in an alkali aqueous solution by ultraviolet exposure. The composition may include a resin dissolved in the alkali aqueous solution, a photosensitive compound that is insoluble in the alkali aqueous solution and is sensitive to ultraviolet light, and other additives.

As an example of the resin dissolved in the alkali aqueous solution, a polyamide derivative may be given. This resin may be transformed into polyamide and polybenzoxazole by heat, thereby exhibiting characteristics of a heat-resistant resin. In a conventional art, a composition not having photosensitivity may be used, however, in recent years, there arises a tendency to prefer a composition having photosensitivity for the purpose of process simplification. A photosensitive composition manufactured by using a general polyamide derivative may exhibit a poor thermal stability to adversely affect pattern formation, or exhibit a significant volume reduction, while being subjected to a crosslinking process at a temperature of about 350°C, and thus a separate crosslink agent may need to be used. In this case, due to characteristics of a compound having crosslink characteristics, a resolution of the pattern may be reduced, and a degree of intermolecular crosslinking may be severe during the crosslinking process, and thereby ductility of inherent characteristics of a polyimide resin may be deteriorated. These additives may reduce sensitivity when forming the pattern, and thereby a process time may be lengthened.

In a recent semiconductor manufacturing process, the photosensitive composition may be coated on a wafer to be subjected to a patterning, and heated at a temperature of about 350°C for one hour so as to perform a crosslinking on a film. When a crosslinking temperature is increased, an adverse influence may be exerted on a semiconductor device. Accordingly, a defective ratio of the semiconductor device may be increased along with an increase in the crosslinking temperature, and thereby a composition by which the crosslinking process is satisfactorily performed event at a relatively low crosslinking temperature may be required.

### SUMMARY

An aspect of the present invention provides a heat-resistant positive typed photosensitive composition that may be readily crosslinked even at a relatively low temperature, thereby preventing a damage in a semiconductor due to a relatively high temperature.

According to an aspect of the present invention, there is provided a positive typed photosensitive composition, including a polyamide derivative being represented by 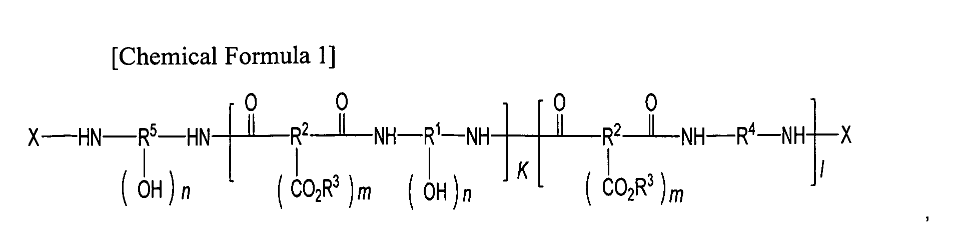 where R¹, R², R⁴, and R⁵ independently represent a bivalent to hexavalent aryl group with at least two carbon atoms, R³ represents either a hydrogen atom or an alkyl group with 1 to 10 carbon atoms, k represents an integer of 10 to 1,000, 1 represents an integer of 1 to 1,000, n and m independently represent an integer of 0 to 2 (n+m>0), and X represents either a hydrogen atom or an aryl group with 2 to 30 carbon atoms.

Additional aspects, features, and/or advantages of the invention will be set forth in part in the description which follows and, in part, will be apparent from the description, or may be learned by practice of the invention.

### EFFECT

According to exemplary embodiments, there is provided a heat-resistant positive typed photosensitive composition that may be readily crosslinked even at a relatively low temperature, thereby preventing a damage in a semiconductor due to a relatively high temperature.

### BRIEF DESCRIPTION OF THE DRAWINGS

These and/or other aspects, features, and advantages of the invention will become apparent and more readily appreciated from the following description of exemplary embodiments, taken in conjunction with the accompanying drawings of which:
FIG. 1 is a graph illustrating a differential scanning calorimeter (DSC) measurement value based on a temperature in a case of Example 5; and
FIG. 2 is a graph illustrating a DSC measurement value based on a temperature in a case of Example 8.

### DETAILED DESCRIPTION

Hereinafter, a positive typed photosensitive composition according to exemplary embodiments will be described in detail.

The positive typed photosensitive composition according to an exemplary embodiment may be crosslinked even at a relatively low temperature while having high sensitivity, and have excellent heat-resistance to reduce an occurrence of defects in a semiconductor due to heat. The photosensitive composition may include a photosensitive compound, a heat-acid generator, and a polyamide derivative being represented by 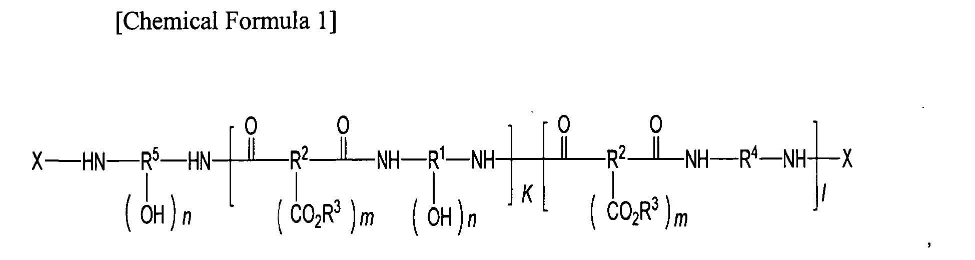 where R¹, R², R⁴, and R⁵ independently represent a bivalent to hexavalent aryl group with at least two carbon atoms, R³ represents either a hydrogen atom or an alkyl group with 1 to 10 carbon atoms, k represents an integer of 10 to 1,000, 1 represents an integer of 1 to 1,000, n and m independently represent an integer of 0 to 2 (n+m>0), and X represents either a hydrogen atom or an aryl group with 2 to 30 carbon atoms.

As an example, the positive photosensitive composition may include a polyamide derivative being represented by 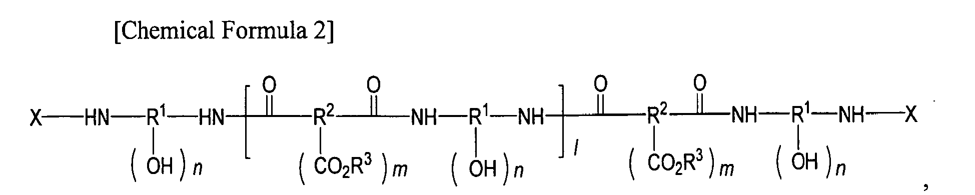 where R¹ and R² independently represent a bivalent to hexavalent aryl group with at least two carbon atoms, R³ represents either a hydrogen atom or an alkyl group with 1 to 10 carbon atoms, k represents an integer of 10 to 1,000, n and m independently represent an integer of 0 to 2 (n+m>0), and X represents either a hydrogen atom or an aryl group with 2 to 30 carbon atoms.

As examples of a compound group of R¹, there may be given compound groups which are represented by the following Chemical Formulas 3 to 23, and the compound groups may be used alone or in combination of two or more of the compound groups.

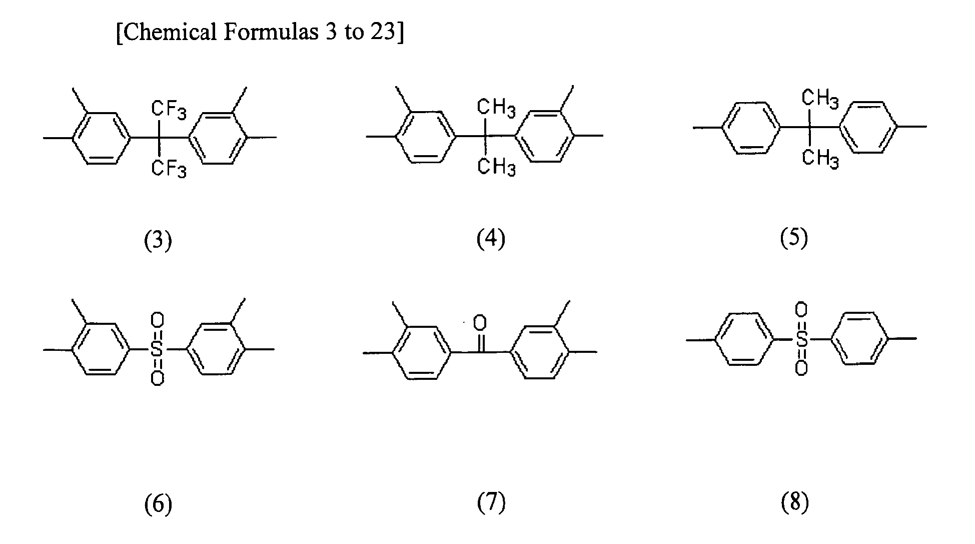

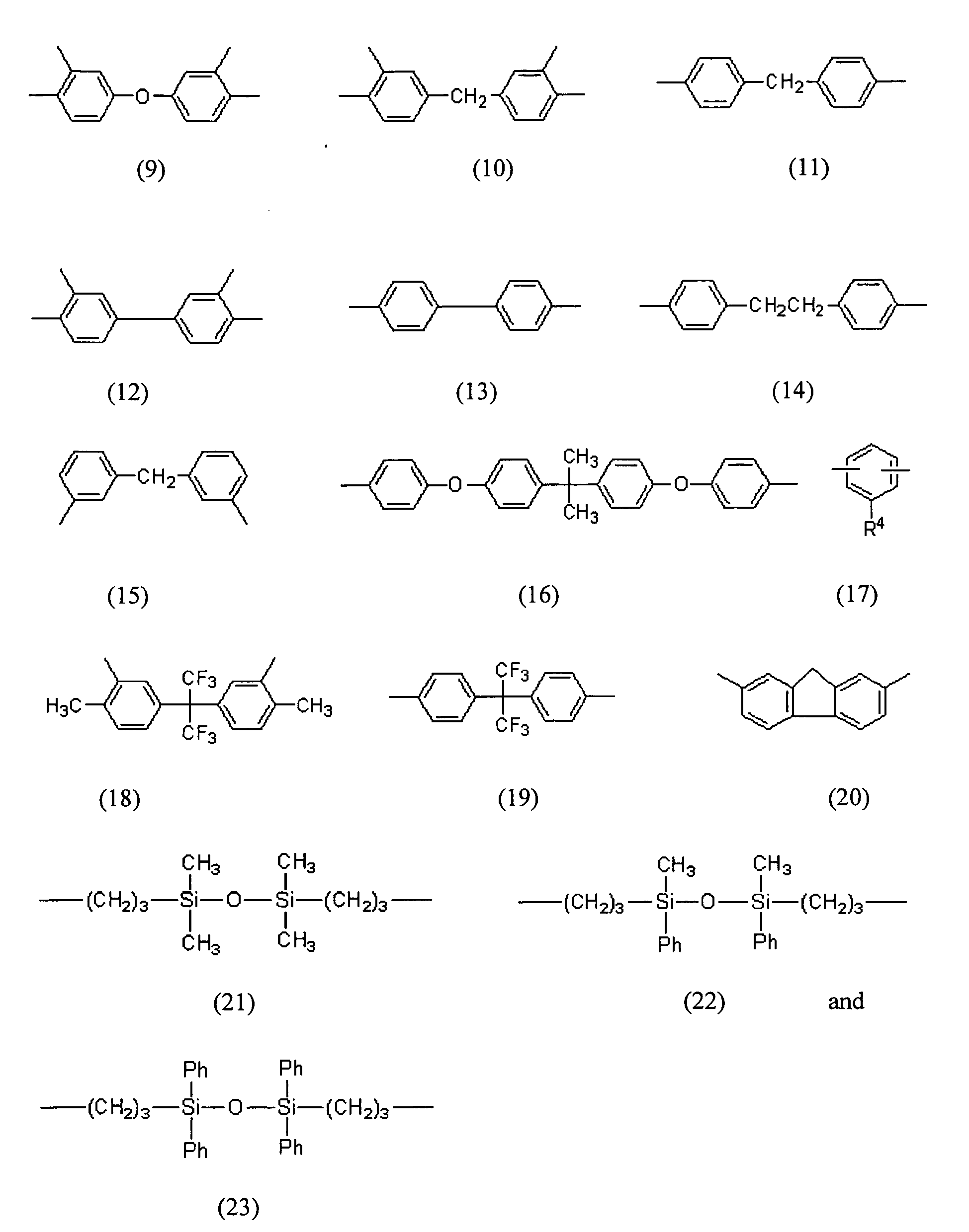

In the above Chemical Formula 17, R⁴ may be one of a hydrogen atom, a halogen atom, a hydroxyl group, carboxyl group, a thiol group, an alkyl group with 1 to 10 carbon atoms, and an aryl group with 1 to 10 carbon atoms.

In the above Chemical Formula 1, as examples of a compound of R², there may be given the compound groups represented by the following Chemical Formulas 24 to 38, and the compound groups may be used alone or in combination of two or more of the compound groups.

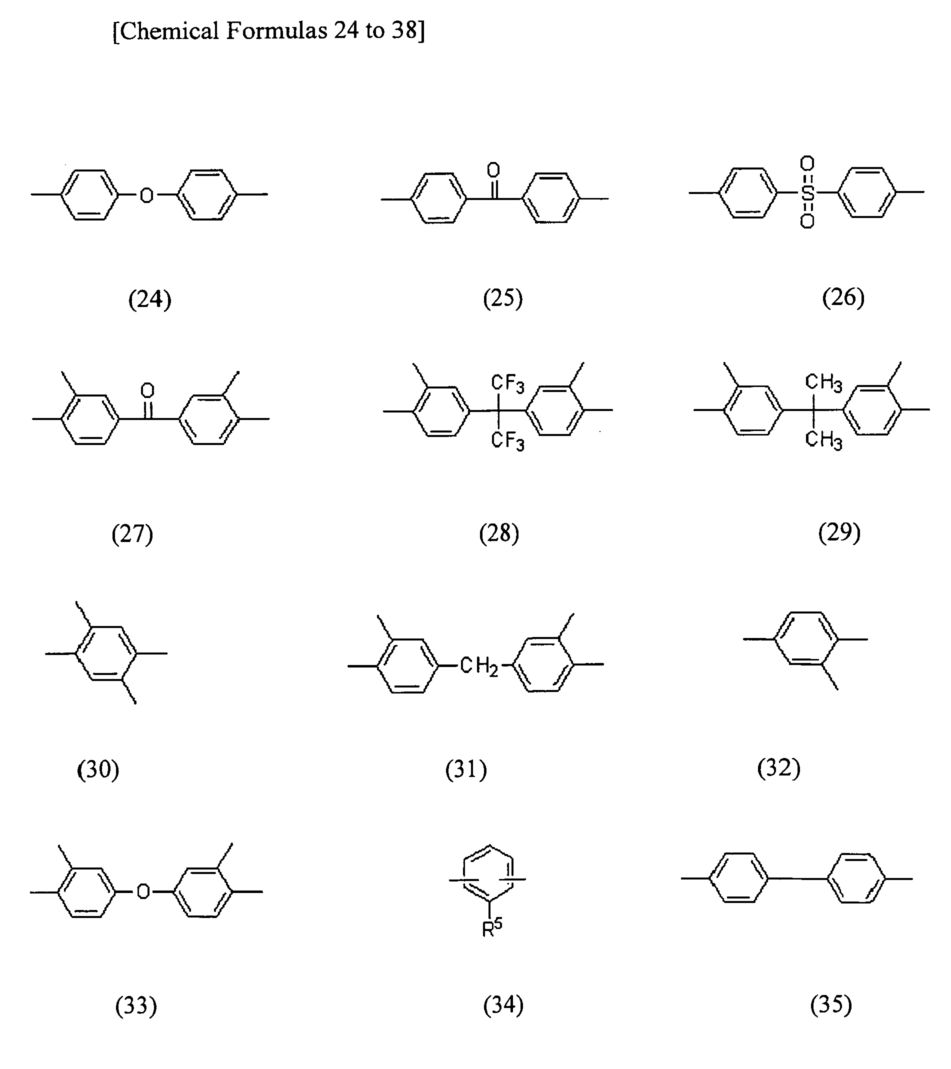

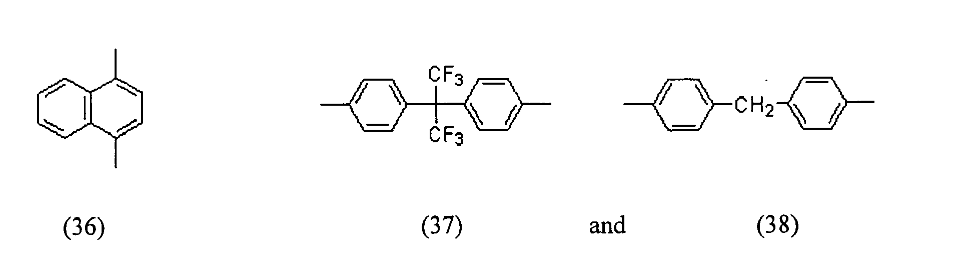

In the above Chemical Formula 34, R⁵ may be one of a hydrogen atom, a halogen atom, a hydroxyl group, carboxyl group, a thiol group, an alkyl group with 1 to 10 carbon atoms, and an aryl group with 1 to 10 carbon atoms.

In polymer synthesis of the above Chemical Formula 1, to adjust a molecular weight and to improve storage stability of a product, an amine group of a main chain of a polymer may be preferably replaced with a chemically stable functional group. There may be various methods of replacing the amine group with the functional group, however, the amine group may be preferably replaced with an amide group. For example, as examples of a compound that is reacted with the amine group to generate the amide group, there may be given an alkylcarbonyl chloride derivative, an alkenylcarbonyl chloride derivative, an alkinylcarbonyl chloride derivative, an alkylsolfonyl chloride derivative, an arylsolfonyl chloride derivative, an alkyl group-containing acid anhydride derivative, an aryl group-containing acid anhydride derivative, an alkenyl group-containing acid anhydride derivative, and the like. However, when using the alkylcarbonyl chloride derivative and the alkenylcarbonyl chloride derivative that have a significantly high chemical reaction speed, the alkylcarbonyl chloride derivative and the alkenylcarbonyl chloride derivative may be reacted with another functional group as well as the amine group of the polymer main chain, and thereby by-products may be disadvantageously generated.

In the above Chemical Formula 1, X may be a hydrogen atom, or a compound group represented by Chemical Formulas 39 to 47 below. However, the present invention may not be limited thereto, and thus a mixture of two or more of the compound groups may be used as X.

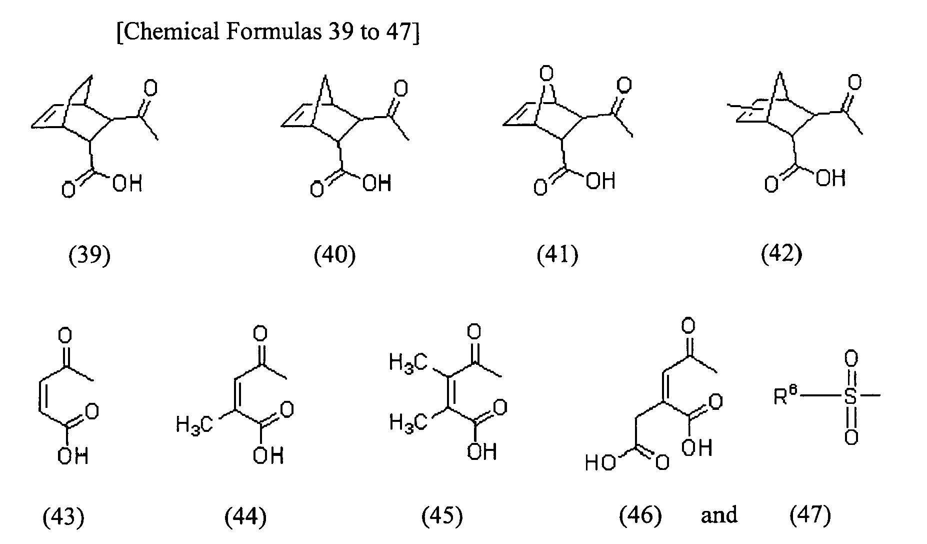

In the above Chemical Formula 47, R⁶ may represent an alkyl group with 1 to 10 carbon atoms or an aryl group with 1 to 10 carbon atoms. That is, an amine group of a main chain may be replaced with an amide group using at least one of the above compounds.

The polymer represented by the above Chemical Formula 1 may be generally manufactured by a condensation reaction. The condensation reaction may be performed such that a dicarboxylic acid derivative is transformed into a dichloride derivative using thionyl, and is subjected to the condensation reaction with a diamine derivative under a basic catalyst. A reaction temperature of the condensation reaction may not be particularly limited, however, and may be preferably about 80°C or less. When the reaction temperature of the condensation reaction is too high, by-products may be generated to deteriorate a development speed or UV transmittance, and the like. However, when the reaction temperature thereof is -10°C or less, a reaction speed may be significantly reduced. A reaction mixture of the condensation reaction may be slowly dropped on a pure material to have the reaction mixture precipitated after the condensation reaction is completed, thereby obtaining a polymer compound of a solid particle type. When a molecular weight of the polymer is relatively great, a used amount of an acid anhydride derivative or a sulfonxyl chloride derivative capable of being reacted with an amine functional group is increased, thereby adjusting the molecular weight of the polymer.

The diazonaphthol compound of the photosensitive compound according to an exemplary embodiment may be obtained by reacting a phenol derivative including at least two hydroxy groups with a diazonaphthol sulfonic chloride derivative under an amine catalyst. The diazonaphthol compound may be represented by 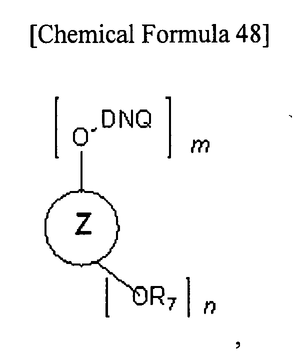 where n and m independently represent an integer of 0 to 5 (n+m>0), Z represents an aryl group with 12 to 40 carbon atoms, DNQ represents Chemical Formula 49 or Chemical Formula 50 below, and R₇ represents one of a hydrogen atom, an alkyl group with 1 to 12 carbon atoms, and an alkylcarbonyl group with 1 to 12 carbon atoms.

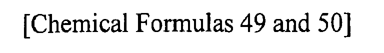

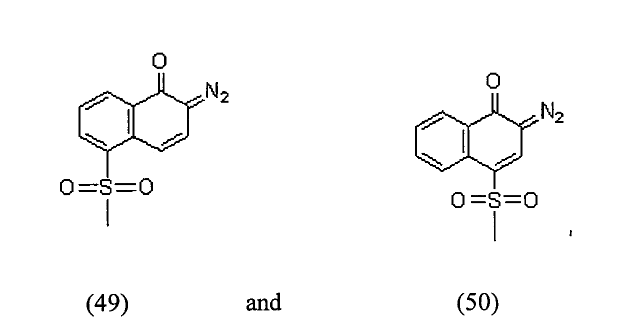

In the above Chemical Formula 48, a ratio of DNQ to R₇ may be 1:4 to 20:1. When the ratio of the DNQ to R₇ is too high, a sensitivity may be reduced, and when the ratio thereof is too low, a perpendicularity of a pattern may be deteriorated. When using an i-line exposurer, a phenol derivative having no ultraviolet absorbance at 365 nm may be preferably used. When the ultraviolet absorbance is relatively high, the perpendicularity of the pattern may be deteriorated. Examples of the diazonaphthol compound may be represented by Chemical Formulas 51 to 58 below, and the present invention is not limited thereto. 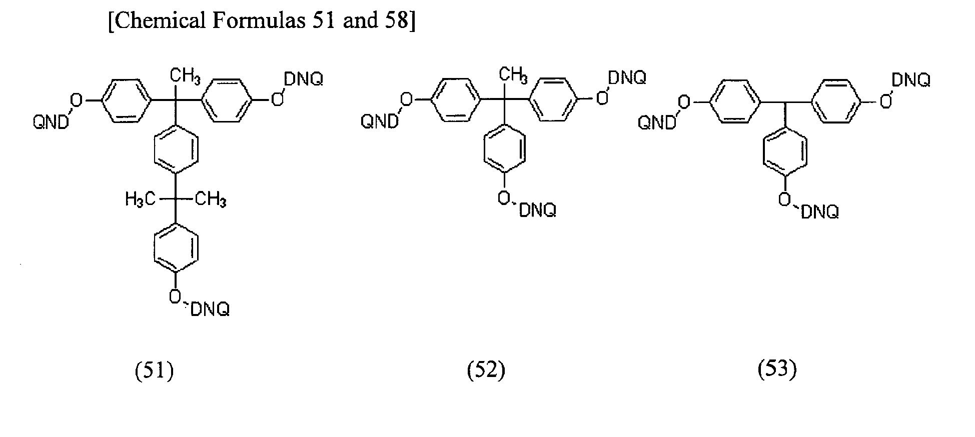 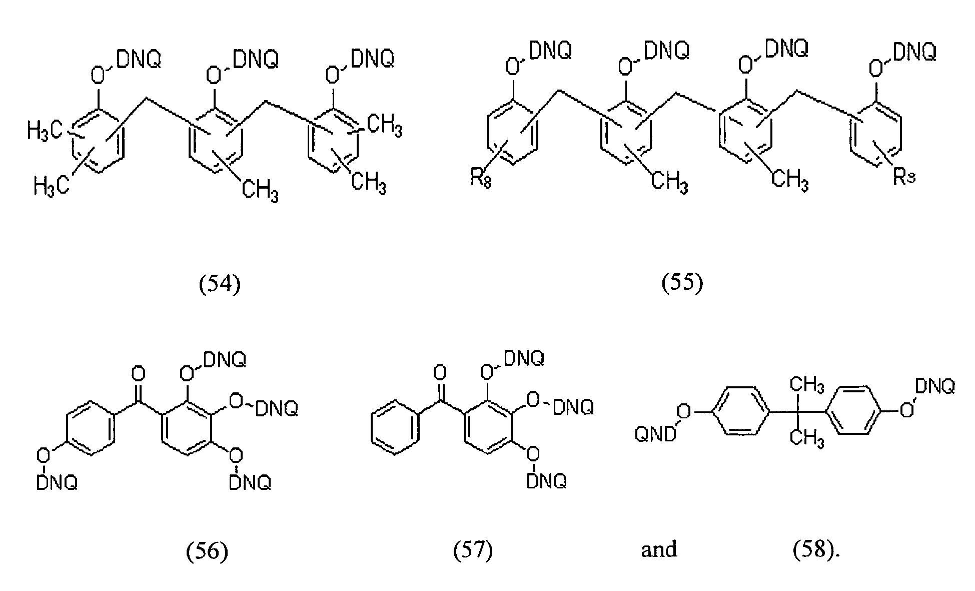 where DNQ represents a compound group being one of a hydrogen atom, an alkylcarbonyl group, a compound group represented by Chemical Formula 49, and a compound group represented by Chemical Formula 50, and R₈ represents a methyl group or a naphthoquinonediazide sulfoxy group (-ODNQ).

The diazonaphthol compound may be used in a mixture of two or more of the diazonaphthol compound. A benzophenone derivative may be preferably used in terms of sensitivity, however, may be unfavorably used in terms of the perpendicularity of the pattern. However, when the benzophenone derivative is mixed in a small amount thereof and used, the sensitivity may be slightly improved instead of deteriorating the perpendicularity. In general, in terms of a UV sensitivity, a 1,2-naphthoquinone-2-diazide-4-sulfonic acid ester derivative may be preferably used rather than a 1,2-naphthoquinone-2-diazide-5-sulfonic acid ester derivative. The diazonaphthol compound may be preferably used in an amount of 5 to 30 parts by weight based on 100 parts by weight of the polyamide compound. When a used amount of the diazonaphthol compound is less than 5 parts by weight, a dissolution suppressing effect is insignificant to have a difficulty in pattern formation, and when the used amount of the diazonaphthol compound is more than 30 parts by weight, a film thickness loss is significantly increased after a thermal crosslinking is performed.

In forming a pattern, the pattern may be basically formed only using the polyamide compound, the diazonaphthol compound, and a solvent. However, as semiconductor devices are highly integrated, a composition having a high resolution, a high sensitivity, and a minimal thickness change after the thermal crosslinking is performed may be required. In order to obtain a composition having the high resolution, the high sensitivity, and a minimal thickness change without deteriorating other physical properties, another additive other than the polyamide compound and the diazonaphthol compound may be required. As an example of the additive, a general low molecular phenol compound may be used. The low molecular phenol compound may be easily obtained, however, the low molecular phenol compound has a relatively low thermal stability, and thereby a formed pattern may not be maintained when the thermal crosslinking is performed at a high temperature of about 300°C or more. In order to overcome this problem, a phenol derivative including a methylol functional group and a separate thermal crosslinking agent may be extensively used. When the thermal crosslinking agent is separately used, the thermal stability may be maintained, however, a ductility of a film subjected to the thermal crosslinking may be deteriorated.

In a process of forming the pattern, bis (4-hydroxyphenyl) fluorine represented by the following Chemical Formula 59 may be used in order to prevent an unexposed portion from being dissolved in a developer after being exposed. The bis (4-hydroxyphenyl) fluorine may increase the thermal stability after hardening the pattern in addition to preventing the unexposed portion from being dissolved in the developer.

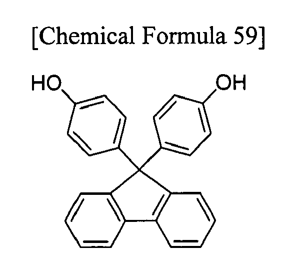

In a recent process of manufacturing the semiconductor device, a relatively low temperature may be needed when forming a polyimide film or a polybenzoxazole film. The relatively low temperature is for maximizing a semiconductor manufacturing yield by minimizing a thermal impact exerted on the semiconductor device. A stable film may be obtained by heating a polyimide precursor or a polybenzoxazole precursor at about 350°C for 30 minutes or more. According to the present invention, a compound in which an acid is generated by heat may be added, thereby reducing a crosslinking temperature by 20°C or more. As an example of the compound in which the acid is generated by heat, there may be given a bivalent-alkyltoluene sulfonate. When the bivalent-alkyltoluene sulfonate is decomposed by a relatively low heat, a scum may occur in an exposed portion when forming the pattern, and when the bivalent-alkyltoluene sulfonate is decomposed by a relatively high heat, effects of the bivalent-alkyltoluene sulfonate may be insignificant. As an example of a bivalent-alkyl arylsulfonate, 2-propyl sulfonate, cycloalkyl sulfonate, 2-hydroxy cyclohexyl sulfonate, and the like may be given, however, the present invention may not be particularly limited thereto. As a used amount of the bivalent-alkyl arylsulfonate, 0.01 to 5% within the whole composition may be appropriate. When the used amount thereof is insufficient, effects thereof may be insignificant, and when the used amount thereof is excessive, an adverse influence may be exerted on a shape of the pattern and an exposed energy.

In manufacturing the composition according to the present invention, a silane coupling agent may be used in order to achieve an adhesive force with a substrate, or a diaminosiloxane monomer of less than 5% may be used in a polymer main chain. When the diaminosiloxane monomer of the polymer main chain of 5% or more is used, a heat resistance may be deteriorated. As examples of the silane coupling agent, there may be given vinyl trimethoxy silane, {3-(2-aminoethylamino)propyl} trimethoxy silane, 3-aminopropyltrimethoxy silane, N-methylaminopropyltrimethoxy silane, 3-glycidoxy-propyltrimethoxy silane, 3-glycidoxy-propyltriethoxy silane, 2-(3,4-epoxycyclohexyl) ethyltrimethoxy silane, 3-methacryloxypropyltrimethoxy silane, 3-mercaptopropyltrimethoxy silane, N-(1,3- dimethylbutylidene)-3-(triethoxysilane)-1-propanamine, N, N-bis (3-trimethoxysilyl) propylethylamine, N-(3-trimethoxysilylpropyl) pyrrole, ureidopropyltrimethoxy silane, (3-triethoxysilylpropyl)-t-butylcarbamate, N-phenylaminopropyltrimethoxysilane, and 3-isocyanatepropyltrimethoxysilane. Of these, 3-glycidoxy-propyltrimethoxy silane and 3-glycidoxy-propyltriethoxy silane, ureidopropyltrimethoxy silane may be superior. A used amount of silane coupling agent may be preferable in an amount of 0.5 to 10 parts by weight based on 100 parts by weight of the polyamide compound. When the used amount thereof is less than 0.5 parts by weight, an adverse influence may be exerted on improvement of the adhesive force, and when the used amount thereof is greater than 10 parts by weight, pattern formation may be suppressed, or the scum may be generated.

An etching process may be performed to remove a lower passivation layer after patterning using the composition according to the present invention. In this instance, to prevent corrosion of an exposed aluminum layer or a conductive wiring layer, an anti-corrosion agent may be added. As a representative example of the anti-corrosion agent, there may be given a catechol derivative, a pyrogallol derivative, an alkyl gallate derivative, and the like in which a hydroxyl group is adjacent to a phenyl group. For example, the present invention is not particularly limited thereto as long as derivatives of catechol, alkyl catechol, alkoxy catechol, pyrogallol, alkyl pyrogallol, alkoxy pyrogallol, alkyl gallate, and the like in which the hydroxyl group is adjacent to the phenyl group. The anti-corrosion agent may be preferable used in an amount of 0.01 to 10% based on the whole composition. When a used amount of the anti-corrosion agent is less than 0.01 %, an anti-corrosion function may be deteriorated, and when the used amount thereof is more than 10%, an amount of loss of the film may be significantly increased when developing.

In addition, a surfactant may be used to improve coating physical properties, and an antifoaming agent may be used to remove foam.

According to the present invention, the composition may be provided by dissolving the above described compositions in the solvent. As examples of the solvent, there may be given gamma-butyrolactone, N-methylpyrrolidone, N, N-dimethylacete amide, dimetylsulfoxide, cyclohexane, 2-heptanone, propylene glycol monomethyl ether acetate, methyl isobutyl ketone, ethylene glycol diethyl ester, ethylene glycol dimethyl ester, ethyllactate, and the like, and the present invention may not be particularly limited thereto. The solvent may be used alone or in a mixture of two or more of the solvent.

A method of forming a pattern using the composition according to the present invention will be herein described in detail. Compositions may be uniformly dissolved in a solvent. Next, this solution may be filtered and coated on a silicon wafer or a glass substrate using spin coating, spray coating, roll coating, and the like to have a desired thickness. The coated substrate may be heated to 50°C to 150°C using a hot plate or infrared to thereby dry the solvent to be removed. A film of the composition generated on the substrate may be subjected to an exposure processing using any one of an i-line exposurer, an h-line exposurer, and a g-line exposurer. The substrate in which a mask pattern is transcripted may be developed, washed, and dried to obtain a pattern. As a developer used in the developing process, tetramethylammonium hydroxide may be used, however, the present invention is not particularly limited thereto as long as a compound exhibits basic properties. To transform the obtained pattern into a polyimide compound or a polybenzoxazole compound, the obtained pattern may be put in an oven at a temperature of about 280°C or more, and heated for several tens of minutes. The obtained film may be used as an interlayer insulating film of a semiconductor or display process, or used as an intermediate protective layer in a packaging process.

The composition according to the present invention may have a superior coating uniformity and a high resolution when developing, while having high sensitivity, and may minimize a shrinkage when a crosslinking is performed.

Hereinafter, the present invention will be described in detail by examples. It is to be understood, however, that these examples are for illustrative purpose only, and are not construed to limit the scope of the present invention. In this instance, an organic timber having been subjected to a dehydration process may be used, and a synthesis of a polymer may be performed under a nitrogen atmosphere.

### Synthesis examples

### Synthesis example 1

### [4,4-oxybisbenzoyl chloride synthesis]

In a 0.5 L flask including an agitator and a thermometer mounted therein, 60g (0.232 mol) of 4,4-oxybisbenzoic acid was added in 240g of N- methylpyrrolidone (NMP), and agitated and dissolved. Next, the flask was cooled down to 0°C, and 110 g (0.9246 mol) of thionyl chloride was dropped on the flask to have a dropped product reacted for one hour, thereby obtaining a 4,4-oxybisbenzoyl chloride solution.

### Synthesis example 2

### [polyamide A synthesis]

400 g of NMP was put in a 1 L flask including an agitator and a thermometer mounted therein, 85 g (0.2321 mol) of 2,2-bis (3-amino-4-hydroxyphenyl) hexafluoropropane was added in the flask, and agitated and dissolved. Next, 39 g (0.4930 mol) of pyridine was added in the flask, and 8 g (0.0487 mol) of 5-norbonen-2,3-dicarboxylic acid anhydride and the synthesized 4,4-oxybisbenzoyl chloride were slowly dropped on the flask. Next, a dropped product was agitated at room temperature for one hour. Next, a solution obtained through the above described process was added in three liters of water to obtain a precipitate. Next, the obtained precipitate was filtered, washed, and vacuum-dried to obtain 128 g of a polyamide A. In this instance, the obtained polyamide had an average molecular weight in terms of polystyrene of 18,500.

### Synthesis example 3

### [dimethyl-3,3', 4,4'-diphenyl ether-tetracarboxylate dichloride synthesis]

60 g (0.1934 mol) of dimethyl-3,3', 4,4'-diphenyl ether-tetracarboxylic acid anhydride, 12.5 g (0.3901 mol) of methyl alcohol, 2 g (0.0198 mol) of triethylamine, and 120 g of NMP were added in a 1 L flask including an agitator and a thermometer mounted therein, and were agitated and reacted at room temperature for four hours to obtain a di-n-methyl-3,3', 4,4'-diphenyl ether-tetracarboxylate solution. Next, the flask was cooled down to about 0°C, 70 g (0.5884 mol) of thionyl chloride was dropped to have a dropped product reacted for two hours, thereby obtaining a dimethyl-3,3', 4,4'-diphenyl ether-tetracarboxylate dichloride solution.

### Synthesis example 4

### [polyamidate B synthesis]

260 g of NMP was put in a 1 L flask including an agitator and a thermometer mounted therein, 65 g (0.1775 mol) of 2,2-bis (3-amino-4-hydroxyphenyl) hexafluoropropane was added, and these reactants were agitated to be dissolved. Next, 35 g (0.4425 mol) of pyridine was added, and the dimethyl-3,3', 4,4'-diphenyl ether-tetracarboxylate dichloride solution was slowly dropped for 30 minutes, and these reactants were agitated for one hour at room temperature. Three liters of water was added to a solution obtained through the above described process to obtain a precipitate. Next, the obtained precipitate was filtered, washed, and vacuum-dried to obtain 128 g of a polyamidate B. In this instance, the polyamidate had an average molecular weight in terms of polystyrene of 19,200.

### Synthesis example 5

### [diazonaphthol compound synthesis/PAC A]

In a round flask, 50 g of tri (4-hydroxyphenyl) ethane, 87 g of 1,2-naphthoquinonediazide-5-sulfonyl chloride, and 17 g of acetic anhydride were dissolved in 800 g of dioxane, and was cooled using ice water. Next, 59 g of triethylamine was slowly dropped on this solution at the same temperature, and the solution was agitated for eight hours at room temperature. Next, the agitated solution was dropped on an excess amount of deionized water to obtain a precipitate. Next, the obtained precipitate was filtered, washed, and vacuum-dried at about 40°C for 48 hours to thereby obtain 95 g of sulfonic ester.

### Synthesis example 6

### [diazonaphthol compound synthesis/PAC B]

In the synthesis example 1, 87 g of 1,2-naphthoquinonediazide-4-sulfonyl chloride was used instead of using 87 g of 1,2-naphthoquinonediazide-5-sulfonyl chloride to thereby obtain 91 g of sulfonic ester.

### Examples

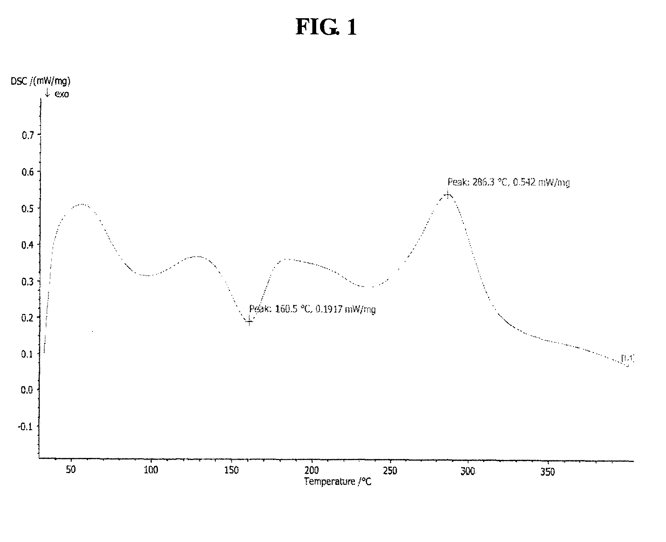

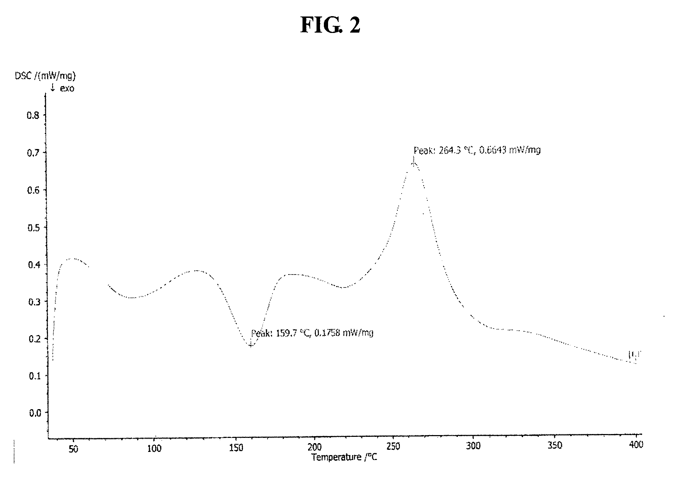

The synthesized polymer, the diazonaphthol compound, and various additives were dissolved in gamma-butyrolactone, acting as a solvent, to be 40 wt%, and particulate foreign substances were removed using 0.5 µm filter. Next, a filtered filtrate was rotation-coated on a silicon wafer of eight inches to have a thickness of 10 µm. In this instance, to completely remove the solvent, a baking was performed on the wafer at about 130°C for 60 seconds. The coated wafer was exposed using an exposure, and developed using tetramethylammonium hydroxide 2.38 wt%. A resolution of the developed wafer was observed using a scanning electron microscope (SEM). As for a thickness of the wafer, a film thickness before and after the exposing was observed using a nano spec. A scum remaining on a bottom of a developed portion was observed using the SEM. A pattern type was divided into good, fair, and poor taking pattern perpendicularity and mask-shaped solid into account. After forming the pattern, a passivation layer was removed by an etching process. Next, a lower aluminum wiring was left out in the air for thirty days to observe a degree of corrosion of the lower aluminum wiring. A temperature in which a main chain of the polymer is changed was measured using a differential scanning calorimeter (DSC) as a tool for measuring an appropriate crosslinking temperature after forming the pattern, and the measured results were shown in FIGS. 1 and 2. FIG. 1 is a graph illustrating a DSC measurement value based on a temperature in a case of Example 5. FIG. 2 is a graph illustrating a DSC measurement value based on a temperature in a case of Example 8.

In the following Chemical Formulas 60 to 63, chemical structures of additives used in the respective Examples are shown. The following Chemical Formulas 60 to 63 respectively represent an additive A, an additive B, an additive C, and an additive D.

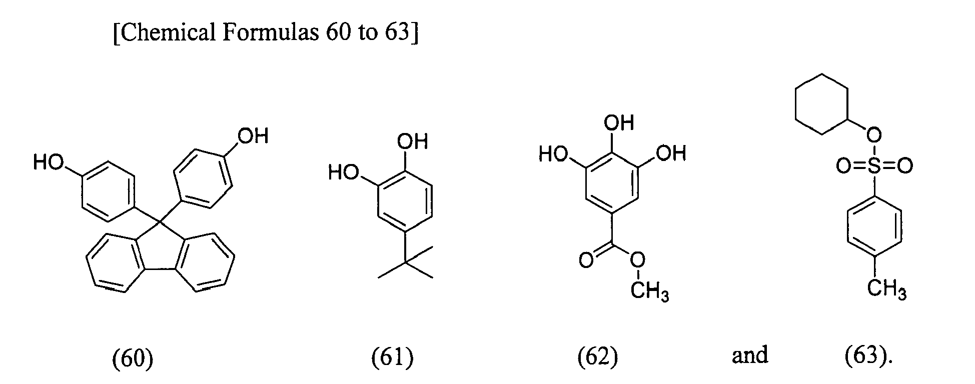

In the following Tables 1 and 2, formations of compositions corresponding to the respective Examples were shown.

**[Table 1]**

| | **Example 1** | **Example 2** | **Example 3** | **Example 4** | **Example 5** |
|---|---|---|---|---|---|
| Polymer | A, 34g | B, 34g | A, 34g | B, 34g | A, 31g |
| PAC | A, 6g | A, 6g | B, 6g | B, 6g | B, 6g |
| Additive 1 | - | - | - | - | A, 3 g |
| Solvent | 60g | 60g | 60g | 60g | 60g |

**[Table 2]**

| | **Example 6** | **Example 7** | **Example 8** |
|---|---|---|---|
| Polymer | A, 30g | A, 30g | A, 29g |
| PAC | B, 6g | B, 6g | B, 6g |
| Additive 1 | A, 3g | A, 3g | A, 3g |
| Additive 2 | B, 1g | C, 1g | C, 1g |
| Additive 3 | - | - | D, 1g |
| Solvent | 60g | 60g | 60g |

### [Test results]

**[Table 3]**

| | **Example 1** | **Example 2** | **Example 3** | **Example 4** | **Example 5** |
|---|---|---|---|---|---|
| Sensitivity | 320mJ/cm² | 320mJ/cm² | 300mJ/cm² | 340mJ/cm² | 320mJ/cm² |
| Residual film ratio | 88% | 90% | 89% | 90% | 88% |
| Resolution | 4 µm | 4 µm | 4 µm | 4 µm | 3 µm |
| Pattern type | good | Good | good | good | best |
| Observation date of corrosion | After 10 days | After 10 days | After 10 days | After 10 days | After 10 days |
| Crosslinking temperature | 320∼350°C | 320∼350°C | 320∼350°C | 320∼350°C | 320∼350°C |

**[Table 4]**

| | **Example 6** | **Example 7** | **Example 8** |
|---|---|---|---|
| Sensitivity | 320 mJ/cm² | 310 mJ/cm² | 300 mJ/cm² |
| Residual film ratio | 88% | 87% | 85% |
| Resolution | 3 µm | 2 µm | 3 µm |
| Pattern type | best | best | best |
| Observation | | | |
| date of corrosion | After 20 days | No change | No change |
| Crosslinking temperature | 320∼350°C | 320∼350°C | 290∼320°C |

Although a few exemplary embodiments of the present invention have been shown and described, the present invention is not limited to the described exemplary embodiments. Instead, it would be appreciated by those skilled in the art that changes may be made to these exemplary embodiments without departing from the principles and spirit of the invention, the scope of which is defined by the claims and their equivalents.

## Claims

1. A positive typed photosensitive composition including a polyamide derivative being represented by 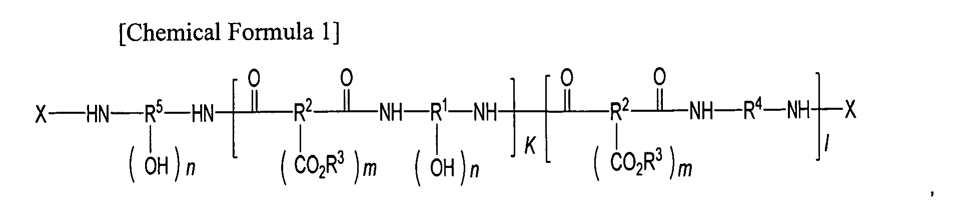 where R¹, R², R⁴, and R⁵ independently represent a bivalent to hexavalent aryl group with at least two carbon atoms, R³ represents either a hydrogen atom or an alkyl group with 1 to 10 carbon atoms, k represents an integer of 10 to 1,000, 1 represents an integer of 1 to 1,000, n and m independently represent an integer of 0 to 2 (n+m>0), and X represents either a hydrogen atom or an aryl group with 2 to 30 carbon atoms.

2. The positive typed photosensitive composition of claim 1, wherein the positive typed photosensitive composition includes a polyamide derivative represented by 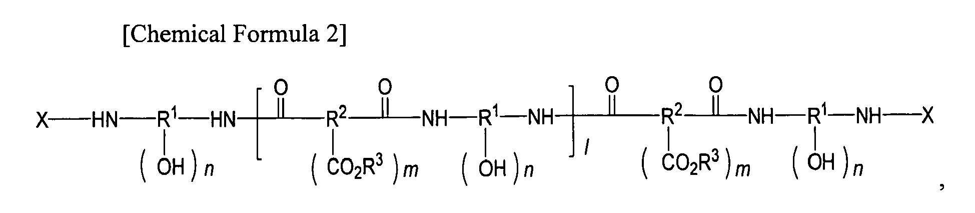 where R¹ and R² independently represent a bivalent to hexavalent aryl group with at least two carbon atoms, R³ represents either a hydrogen atom or an alkyl group with 1 to 10 carbon atoms, k represents an integer of 10 to 1,000, n and m independently represent an integer of 0 to 2 (n+m>0), and X represents either a hydrogen atom or an aryl group with 2 to 30 carbon atoms.

3. The positive typed photosensitive composition of claim 1, wherein the positive typed photosensitive composition has a crosslinking temperature of about 330°C or less.

4. A positive typed photosensitive composition including a diazonaphthol compound, a heat-acid generator, and a polyamide compound represented by 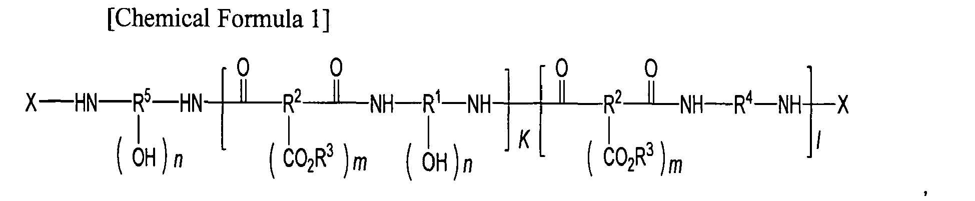 where R¹, R², R⁴, and R⁵ independently represent a bivalent to hexavalent aryl group with at least two carbon atoms, R³ represents either a hydrogen atom or an alkyl group with 1 to 10 carbon atoms, k represents an integer of 10 to 1,000, 1 represents an integer of 1 to 1,000, n and m independently represent an integer of 0 to 2 (n+m>0), and X represents either a hydrogen atom or an aryl group with 2 to 30 carbon atoms.

5. The positive typed photosensitive composition of claim 4, wherein the heat-acid generator includes a bivalent alkyl toluene sulfonate.

6. The positive typed photosensitive composition of claim 4, wherein the positive typed photosensitive composition includes the polyamide derivate represented by Chemical Formula 1, the diazonaphthol compound, and at least one of additives represented by Chemical Formulas 3 to 6, Chemical Formulas 3 to 6 being

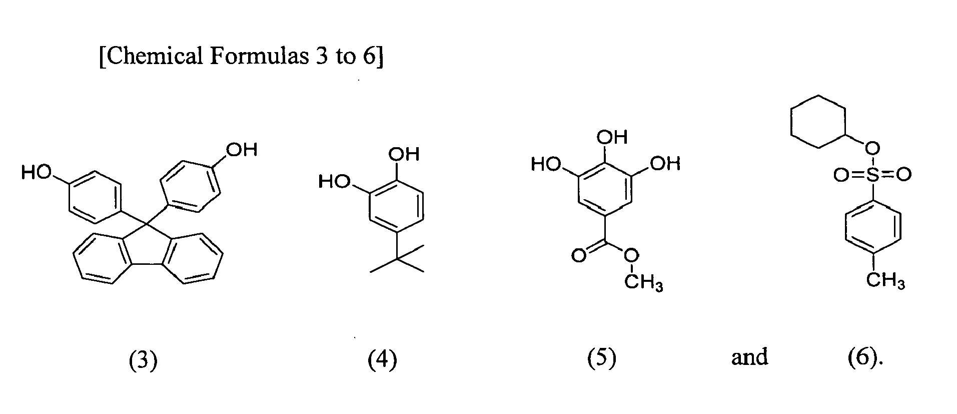

7. The positive typed photosensitive composition of claim 4, wherein the diazonaphthol compound is represented by 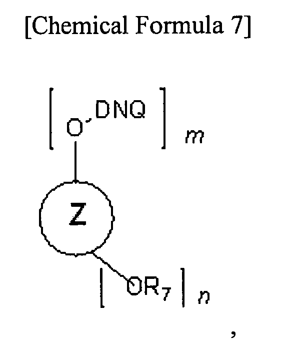 where n and m independently represent an integer of 0 to 5 (n+m>0), Z represents an aryl group with 12 to 40 carbon atoms, below, R₇ represents one of a hydrogen atom, an alkyl group with 1 to 12 carbon atoms, and an alkylcarbonyl group with 1 to 12 carbon atoms, and DNQ is represented by Chemical Formulas 8 or 9, Chemical Formulas 8 and 9 respectively being

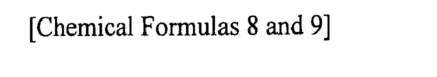

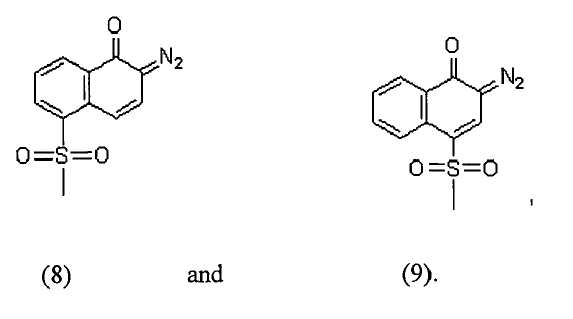

8. The positive typed photosensitive composition of claim 7, wherein a molar ratio of DNQ to R₇ is 1:4 to 20:1.

9. The positive typed photosensitive composition of claim 4, wherein the diazonaphthol compound is at least one compound selected from a group consisting of compounds being represented by Chemical Formulas 10 to 17, 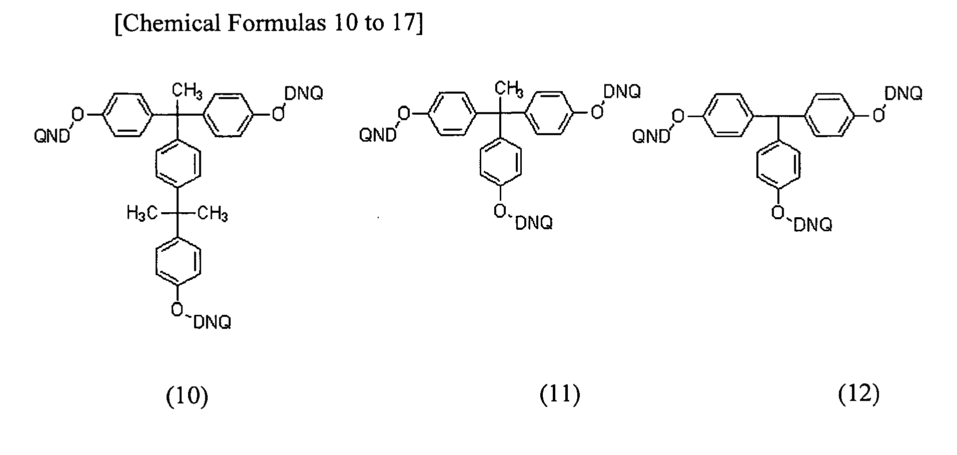 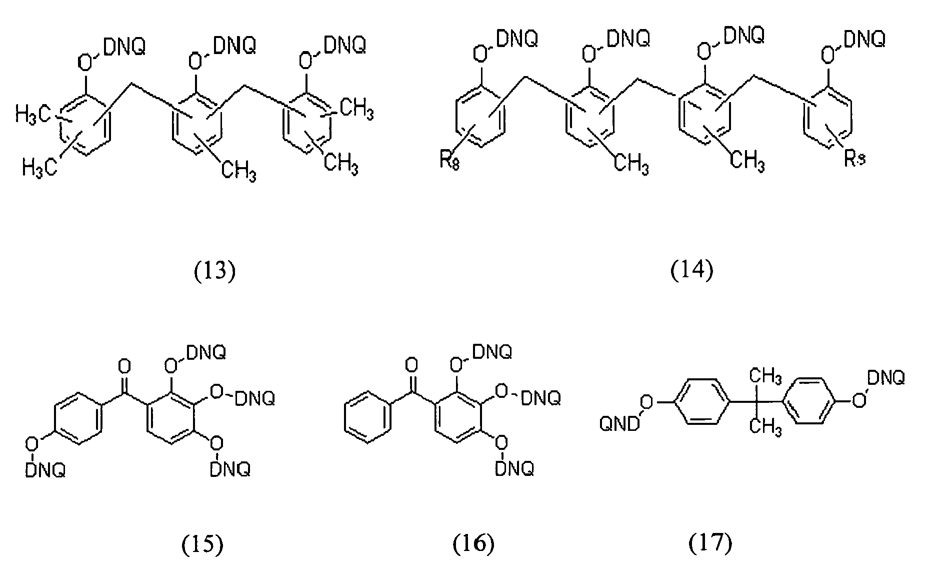 where the DNQ is one of a hydrogen atom, an alkylcarbonyl group, a compound group represented by Chemical Formula 18, and a compound group represented by Chemical Formula 19, and R₈ represents either a methyl group or a naphthoquinonediazide sulfoxy group (-ODNQ).

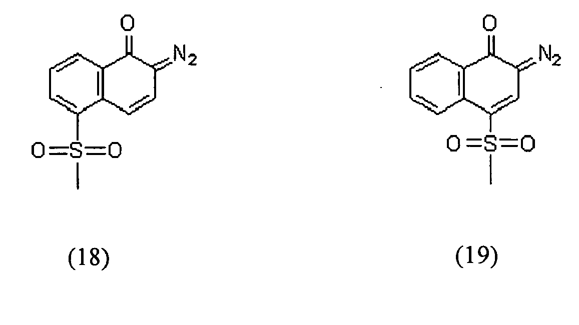

10. The positive typed photosensitive composition of claim 4, wherein the diazonaphthol compound is contained in the whole composition, in an amount of 5 to 30 parts by weight based on 100 parts by weight of the polyamide derivative.

11. The positive typed photosensitive composition of claim 4, wherein the heat-acid generator is contained in the whole composition, in an amount of 0.01% to 5%.
